# EUROPÄISCHE PATENTANMELDUNG

(11) **EP 3 302 011 A1**
(43) Veröffentlichungstag der Anmeldung: **04.04.2018**
(21) Anmeldenummer: 16465541.7
(22) Anmeldetag: 29.09.2016
(51) Int. Cl.: H05K 5/06, H05K 5/02

(54) **ELEKTRONIKBAUGRUPPE MIT EINEM GEHÄUSE UND EINEM DRUCKAUSGLEICHSKANAL**

(71) Anmelder: Continental Automotive GmbH, 30165 Hannover (DE)
(72) Erfinder: Goron, Gabriel, 300003 Timisoara (RO)
(74) Vertreter: Büchner, Jörg

(57) **Zusammenfassung**

Es wird eine Elektronikbaugruppe mit einem Gehäuse (11,13) und einem zumindest abschnittsweise im Inneren (14) des Gehäuses angeordneten elektronischen Schaltung (15) sowie einem Druckausgleichskanal (12) durch das Gehäuse zum Druckausgleich zwischen dem Inneren des Gehäuses und der Umgebung, dadurch gekennzeichnet, dass zumindest ein Abschnitt des Druckausgleichskanals (12) mit einem wasserdichten, jedoch druckdurchlässigen Schaumstoff (2A, 2B, 2C) gefüllt ist.

## Beschreibung

Die Erfindung betrifft eine Elektronikbaugruppe gemäß dem Oberbegriff von Anspruch 1.

Gerade im Bereich der Automobilelektronik werden heutzutage eine Vielzahl von Elektronikbaugruppen eingesetzt, welche erheblichen Temperaturänderungen als auch einer feuchtigkeitshaltigen und mit Schmutz und aggressiven chemischen Stoffen versetzten Umgebung ausgesetzt.

Im Inneren des Gehäuses die elektronische Schaltung mit Leiterbahnen und empfindlichen elektronischen Komponenten, beispielsweise auch Sensoren und Mikroprozessoren angeordnet. Die Schaltung kann vollständig vom Gehäuse umschlossen sein, aber eben auch evtl. nur abschnittsweise, bspw. entsprechende Anschlussbereiche für die Kontaktierung aus dem Gehäuse herausragen, wobei dann eine entsprechende druck- und feuchtigkeitsundurchlässige Versiegelung dieses Gehäusedurchgangs üblich ist.

Die elektrische Schaltung und deren Komponenten im Innenraum des Gehäuses müssen vor Partikeln und insbesondere Feuchtigkeit aus der Umgebung geschützt werden, um eine Beschädigung, beispielsweise durch Korrosion oder einen Kurzschluss, zu verhindern. Dazu sollen das Gehäuse und der Steckverbinder im angekoppelten Zustand dicht gegenüber Feststoffen, Flüssigkeiten und Gasen aus dem Motorraum, typischerweise mittels Dichtungen, ausgebildet sein. Eine solche Dichtigkeit kann jedoch nur bis zu einer vorbestimmten Druckdifferenz aus einem Innendruck in der Elektronikbaugruppe und einem Außendruck gewährleistet werden. Übersteigt die Druckdifferenz, beispielsweise auf Grund einer Erwärmung von Luft in dem Inneren des Gehäuses oder aber im Außenraum, den vorbestimmten Wert, so verformen sich die Dichtungen derart, dass ein Stoffaustausch zwischen dem Steuergerätmodul und der Umgebung stattfindet. Diesen Stoffaustausch gilt es jedoch zu vermeiden.

Ein erster bspw. aus der DE 19946825 C1 bekannter Ansatz sieht eine Entlüftung des Steuergerätes und des Steckverbinders über den angekoppelten Kabelbaum vor. Dabei besitzt der Kabelbaum gasleitende Litzen, die auf der einen Seite an ein Luftvolumen außerhalb des Motorraums angeschlossen sind und auf der anderen Seite an den Steckverbinder des Steuergerätmoduls angeschlossen sind. Der Steckverbinder selbst wiederum ist mittels eines Kanals mit dem Innenraum des Steuergeräts verbunden. Zieht sich beispielsweise Luft im Innenraum des Steuergeräts auf Grund einer Abkühlung zusammen, so kann von außerhalb des Motorraums durch die Litze im Kabelbaum, durch den Steckverbinder und durch den Kanal Luft in das Innere des Steuergerätsnachgeführt werden, solange bis der Innendruck im Gehäuse wieder im Wesentlichen dem Außendruck im Motorraum entspricht.

Bei einem zweiten bspw. aus der EP 862354 A2 bekannten Ansatz, der sich mit der oben aufgezeigten Problematik befasst, ist eine spezielle Druckausgleichseinrichtung zur Entlüftung des Steuergerätes in dem Steuergerätmodul vorgesehen. Dazu ist der Innenraum des Gehäuses des Steuergeräts durch einen druckleitenden Kanal mit dem sogenannten Druckausgleichselement verbunden. Das Druckausgleichelement ist dabei typischerweise als gasleitende Membran, die undurchlässig für Feststoffe oder Flüssigkeiten ist, ausgebildet und sind beispielsweise unter dem Markennamen GoreTex o.dgl. bekannt. Derartige Membrane sind jedoch teuer, müssen aufwendig verklebt werden und kann sich die doch recht begrenzte Oberfläche der Membran durch Schmutz aus der Umgebung so zusetzen, dass der erforderliche Druckausgleich nicht mehr hinreichend gut möglich ist.

Ein 3. Lösungsansatz basiert auf einer elastischen, aber gasundurchlässigen Ballonhaut, welche durch Volumenänderung innerhalb des Ballons einen Druckausgleich ermöglicht. Diese Lösung benötigt jedoch einen erheblichen Bauraum und die Kunststoffzusammensetzung der Ballonhaut oft leider für die erforderliche Lebensdauer in einer Anwendung in der Automobilelektronik nicht sicher genug, da verwendete Weichmacher über die Jahre hinweg und die doch recht großen Temperaturschwankungen hinweg entweichen.

Die Aufgabe der vorliegenden Erfindung ist es, einen weiteren geeigneten Lösungsansatz vorzustellen. Diese Aufgabe wird durch die Merkmale der unabhängigen Ansprüche gelöst. Vorteilhafte Weiterbildungen der Erfindung ergeben sich aus den Unteransprüchen, wobei auch Kombinationen und Weiterbildungen einzelner Merkmale miteinander denkbar sind.

Ein wesentlicher Gedanke der Erfindung besteht darin, dass zumindest ein Abschnitt des Druckausgleichskanals mit einem geeigneten Schaumstoff gefüllt wird.

Durch die EP 833853 A1 oder auch die EP 1200 238 A1 sind mittlerweile Verfahren zur Herstellung und damit auch entsprechende Schaumstoffe bekannt, welche über ihre chemische Zusammensetzung und Struktur für die hier geforderten Anwendungen einerseits sich als hinreichend wasserdicht erweisen, andererseits aber auch im erforderlichen Maße druckdurchlässig sind.

Im Gegensatz zu den bekannten Membranen, welche in der Regel aus eben einer Lage von entsprechend engmaschig miteinander verwebten Kunststofffasern bestehen, sind die Schaumstoffe in sich chemisch verbundene Polymerpartikel und vergleichbar einem Schwamm elastisch und mit einer Vielzahl von winzigen Gasbläschen versehen, über die definierte Dicke und Konzentration der Partikel insgesamt jedoch eben entsprechend hinreichend wasserdicht, wobei die Wasserdichtheit dabei nicht ausschließt, dass in die Oberfläche eines solchen Schaumstoff Wasserzeichen eindringen können, sondern nur, dass über die entsprechende Dicke des Schaumstoffs und Länge eines entsprechend damit gefüllten Abschnitts des Druckausgleichskanals letztendlich die hinreichende Dichtheit erreicht wird. Eine wasserabweisende Außenbeschichtung oder gar wasserdichte Membran oder Hülle sind daher gerade nicht erforderlich.

Der Schaumstoff weist vorzugsweise in Richtung des Druckausgleichskanals zumindest eine vorgegebene Dicke auf, welche insbesondere um mindestens den Faktor 10 größer ist als die Dicke herkömmlicher Druckausgleichs-Membranen, insbesondere die Dicke mindestens ... mm.

Vorzugsweise füllt der Schaumstoff in zumindest einem Bereich dieses Abschnitts den Querschnitt des Druckausgleichskanals vollständig aus. Der Schaumstoff ist insbesondere sogar bevorzugt zumindest in Querrichtung des Druckausgleichskanals um ein vorgegebenes Maß komprimiert, weist also der Schaumstoff im Ruhezustand vor dem Einführen in den Druckausgleichskanal eine Größe in Querrichtung auf, welche größer ist als das Quermaß des Druckausgleichskanals.

In einer besonders bevorzugten Ausgestaltung ist zudem vorgesehen, dass der Schaumstoff aus dem zur Umgebung hin gerichteten Ende des Druckausgleichskanals herausragt und dort eine Gesamtoberfläche zur Umgebung hin größer, vorzugsweise mindestens das Doppelte, als die Querschnittsfläche innerhalb des Druckausgleichskanals aufweist. Dabei wird der besondere Vorteil dieser in sich zusammenhängenden Schaumstoffe ausgenutzt und kann eine deutlich größere Oberfläche für den Druckausgleich genutzt werden.

Der Schaumstoff kann dabei als ein fertiger Formkörper in den Druckausgleichskanal eingeführt werden, ggfs. unter Verwendung geeigneter Führungswerkzeuge. Alternativ kann auch ein chemisch und/oder physikalisch noch aktiv aufquellender Stoff bzw. Stoffgemisch eingebracht, bspw. eingespritzt werden, welcher dann erst die letztendliche Form und Struktur einnimmt, in welcher dann die geforderte Dichtheit erreicht wird, ohne dass die ja ebenfalls geforderte Atmungsaktivität bzw. der Druckausgleich verhindert wird. So ist beispielsweise in Betracht gezogen, die noch flüssige Schaumstoffrohmasse mit entsprechendem Treibgas und Katalysatoren in den Druckausgleichskanal einzuspritzen und die Formgebung außerhalb des Kanals durch eine entsprechende Spritzgussformen definiert.

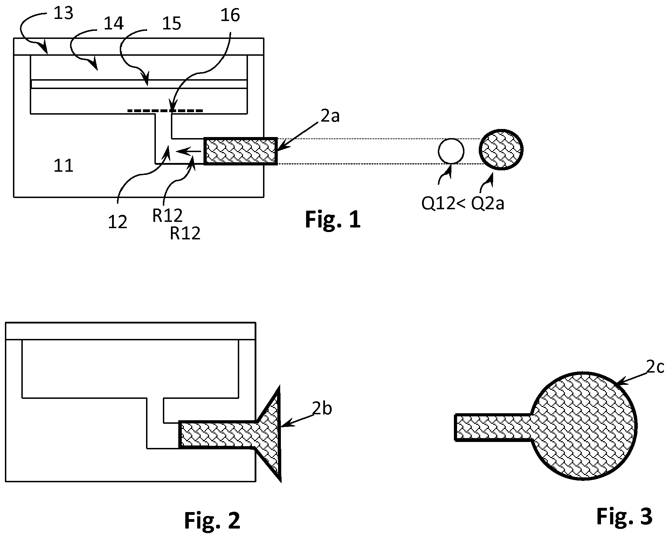

Die Erfindung wird nachfolgend noch anhand von Figuren und Ausführungsbeispiel in noch näher beschrieben. So zeigt Figur 1 eine Elektronikbaugruppe mit einem Gehäuse bestehend aus einem Gehäuseunterteil 11 und einem Deckel 13, wobei die Ausrichtung, Formgebung und die dargestellten Dimensionen rein skizzenhaft sind. Im Gehäuse ist in dem entstehenden Gehäuseinnenraum 14 die elektronische Schaltung 15 mit entsprechenden elektronischen Bauelementen, insbesondere auch elektronischen Sensorbaugruppen und deren Auswerteschaltung angeordnet.

Zudem weist das Gehäuse einen Druckausgleichskanal 12 auf, wobei für die Erfindung unerheblich ist, in welchem Gehäuseteil diese angeordnet ist und sind die Proportionen dieses Druckausgleichskanals 12 in Bezug auf die Größe des Gesamtgehäuses hier zur besseren Visualisierung der Erfindung bewusst übertrieben und vergrößert dargestellt und in Realität in der Regel in Proportion kleiner. Wie durch die Figur 1 skizzenhaft angedeutet sein soll, kann die sonst üblicherweise vorgesehene Druckausgleichs-Membran 16 bei der erfindungsgemäßen Ausgestaltung entfallen.

Wie skizzenhaft in Figur 1 zu erkennen, ist zumindest ein Abschnitt des Druckausgleichskanals 12 mit einem Schaumstoff 2A gefüllt, welcher erfindungsgemäß entsprechend der vorgegebenen Parameter hinreichend wasserdicht, jedoch druckdurchlässig ist.

Die Richtung R 12 des Druckausgleichskanals 12 ist dabei durch die Strömungsrichtung definiert, welche sich bei einem durch den Druckausgleichskanal 12 geschickten Luftstrom ergeben würde. Senkrecht dazu ist die Querschnittsfläche Q12 des Druckausgleichskanals 12 definiert und dessen Größe skizzenhaft in Figur 1 ebenfalls dargestellt.

In dieser bevorzugten Ausgestaltung weist der Schaumstoff 2A in Richtung R12 des Druckausgleichskanals 12 zumindest eine vorgegebene Dicke, bspw. mindestens 10 mm auf - ist also in jedem Fall deutlich dicker als herkömmliche gewebeförmige Druckausgleichs-Membranen.

Der Schaumstoff füllt den Querschnitt des Druckausgleichskanals in diesem Abschnitt nicht nur vollständig aus, sondern ist zudem um ein vorgegebenes Maß komprimiert.

Der Schaumstoff 2A weist also im Ruhezustand vor dem Einführen in den Druckausgleichskanal 12 eine Größe Q2A in Querrichtung auf, welche größer ist als das Quermaß Q12 des Druckausgleichskanals 12, d.h. es gilt Q12<Q2a.

Der Schaumstoff ragt zudem in den hier gezeigten Ausführungsbeispielen aus dem zur Umgebung hin gerichteten Ende des Druckausgleichskanals 12 heraus und weist dort eine Gesamtoberfläche zur Umgebung hin größer, vorzugsweise mindestens das Doppelte, als die Querschnittsfläche innerhalb des Druckausgleichskanals auf. Dazu kann die besondere Formgebung des Schaumstoffs gerade in diesem Bereich außerhalb des Druckausgleichskanals 12 auch die in den Figuren 2 und 3 gezeigten Ausführungsbeispiele 2B oder 2C sowie auch weitere entsprechende Formen aufweisen, bei welchen jeweils die Gesamtoberfläche zur Umgebung hin entsprechend deutlich vergrößert ist gegenüber der Querschnittsfläche Q12 innerhalb des Kanals. Diese große Oberfläche ermöglicht es, trotz eines eventuellen Einflusses von Schmutzartikeln aus der Umgebung ein Zusetzen der Gesamtoberfläche zu verhindern

Die hier vorgesehenen Schaumstoffmaterialien sind deutlich preiswerter als Druckausgleichs-Membrane und weisen in der Regel eine sehr große Formstabilität über einen großen Temperaturbereich auf und können durch ihre in der Regel elastische Verformbarkeit sehr gut und mit wenigen Produktvarianten an die einzelnen Druckausgleichskanäle angepasst werden, d.h. mit wenigen Formen ein großer Toleranzbereich abgedeckt werden kann.

Gerade bei Anwendung für so genannte Sensorsatelliten in Kraftfahrzeugen, also in den Außenbereich des Fahrzeugs ausgelagerte Elektronikeinheiten mit Sensoren ist es von entscheidender Bedeutung, dass diese in einer mit Schmutz und Wasser kontaminierten Umgebung angeordnet werden können und trotzdem die teils erheblichen Temperaturunterschiede im Kraftfahrzeug aushalten. Durch den Schaumstoff kann auch verhindert werden, dass Feuchtigkeit oder gar Wasser sich im Druckausgleichskanal absetzt und dort beispielsweise bei entsprechenden Außentemperaturen festfriert.

Durch die Formgebung kann zu dem eventuell in diesem Bereich entlangströmende Wasser sogar gezielt zur Reinigung der Oberfläche genutzt werden oder zumindest hinreichend gut sichergestellt werden, dass dieses nicht in den eigentlichen Druckausgleichskanal eindringen kann.

Selbstverständlich kann der Schaumstoff 2A, 2B, 2C auch in einer Kammer des Gehäuses so angeordnet sein, dass der Schaumstoff gegen direkte Einwirkung von Schmutz oder Wasserstrahl geschützt ist.

## Patentansprüche

1. Elektronikbaugruppe mit einem Gehäuse (11,13) und einem zumindest abschnittsweise im Inneren (14) des Gehäuses angeordneten elektronischen Schaltung sowie einem Druckausgleichskanal (12) durch das Gehäuse (11,13) zum Druckausgleich zwischen dem Inneren des Gehäuses und der Umgebung, **dadurch gekennzeichnet, dass** zumindest ein Abschnitt des Druckausgleichskanals (12) mit einem wasserdichten, jedoch druckdurchlässigen Schaumstoff (2A, 2B, 2C) gefüllt ist.

2. Elektronikbaugruppe nach Anspruch 1, **dadurch gekennzeichnet, dass** der Schaumstoff (2A, 2B, 2C) in Richtung (R12) des Druckausgleichskanals (12) zumindest eine vorgegebene Dicke aufweist.

3. Elektronikbaugruppe nach Anspruch 1 oder 2, **dadurch gekennzeichnet, dass** der Schaumstoff (2A, 2B, 2C) in zumindest einem Bereich dieses Abschnitts den Querschnitt (Q12) des Druckausgleichskanals (12) vollständig ausfüllt.

4. Elektronikbaugruppe nach Anspruch 3, **dadurch gekennzeichnet, dass** der Schaumstoff (2A, 2B, 2C) zumindest in Querrichtung des Druckausgleichskanals (12) um ein vorgegebenes Maß komprimiert ist.

5. Elektronikbaugruppe nach einem der vorangehenden Ansprüche, **dadurch gekennzeichnet, dass** der Schaumstoff (2A, 2B, 2C) aus dem zur Umgebung hin gerichteten Ende des Druckausgleichskanals (12) herausragt und dort eine Gesamtoberfläche zur Umgebung hin größer, vorzugsweise mindestens das Doppelte, als die Querschnittsfläche innerhalb des Druckausgleichskanals (12) aufweist.

6. Elektronikbaugruppe nach einem der vorangehenden Ansprüche, **dadurch gekennzeichnet, dass** diese eine Sensorbaugruppe mit einem Sensorelement ist.
